# EUROPEAN PATENT APPLICATION

(11) **EP 4 776 323 A1**
(43) Date of publication of application: **15.07.2026**
(21) Application number: 25151645.6
(22) Date of filing: 14.01.2025
(51) Int. Cl.: H01J 37/02, H01J 37/26

(54) **DISCHARGE DAMAGE MITIGATION UNIT**

(71) Applicant: ASML Netherlands B.V., 5500 AH Veldhoven (NL)
(72) Inventor: VAN DER TOORN, Jan-Gerard, Cornelis, 5500 AH Veldhoven (NL); BAARS, Norman, Hendrikus, Rudolf, 5500 AH Veldhoven (NL); HEMPENIUS, Peter, Paul, 5500 AH Veldhoven (NL); VAN AAKEN, Willem, Petrus, 5500 AH Veldhoven (NL); EBERT, Martin, San Jose, CA 95134 (US); LOOMAN, Bram, Albertus, 5500 AH Veldhoven (NL); LEEUWENHOEK, Maarten, 5500 AH Veldhoven (NL); BASTIAANS, Koen, Mathijs, 5500 AH Veldhoven (NL); DE LANGEN, Johannes, Cornelis, Jacobus, 5500 AH Veldhoven (NL)
(74) Representative: ASML Netherlands B.V.

(57) **Abstract**

The present invention provides a discharge damage mitigation unit for use in a charged particle beam assessment apparatus for projecting a beam of charged particles towards a sample. The discharge damage mitigation unit is configured for use in a high electric field environment. The discharge damage mitigation unit comprises one or more extension elements configured to receive a discharge from a high electric field element at a different electrical potential in the high electric field environment. Each extension element is arranged outside of a beam path region encompassing a beam path of the beam of charged particles. Each extension element is supported on a component of the charged particle beam assessment apparatus, wherein a distal region of the extension element is configured to protrude from a surface of the component.

## Description

### FIELD

The present invention relates to discharge damage mitigation unit for use in a charged particle beam assessment apparatus.

### BACKGROUND

During manufacturing processes of, for example, semiconductor integrated circuit (IC) chips or displays, undesired defects may occur on a substrate (e.g. wafer or a mask). Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation and even light.

The assessment apparatus, used for the assessment of the sample, may comprise components configured to operate at a relatively high voltage, leading to potential differences between different components. The assessment apparatus may be designed to account for the presence of a high electric field. Nonetheless, unintended electrical discharges still occur. A discharge can cause damage, particularly to the lower potential difference component. There is therefore a problem that components of the assessment apparatus, or even the sample being assessed, may be damaged due to discharge. This damage may result in a loss of throughput of the assessment apparatus due, for example, to downtime to perform repairs.

### SUMMARY

It is an object of the present disclosure to provide embodiments of a discharge damage mitigation unit to reduce an amount and/or likelihood of damage due to unintentional electrical discharge in a charged particle beam assessment apparatus.

According to an aspect of the invention, there is provided a discharge damage mitigation unit for use in a charged particle beam assessment apparatus for projecting a beam of charged particles towards a sample. The discharge damage mitigation unit is configured for use in a high electric field environment. The discharge damage mitigation unit comprises one or more extension elements configured to receive a discharge from a high electric field element at a different electrical potential in the high electric field environment. Each extension element is arranged outside of a beam path region encompassing a beam path of the beam of charged particles. Each extension element is supported on a component of the charged particle beam assessment apparatus, wherein a distal region of the extension element is configured to protrude from a surface of the component.

According to another aspect of the invention, there is provided a charged particle beam assessment apparatus for projecting a beam of charged particles towards a sample, comprising the discharge damage mitigation unit.

### BRIEF DESCRIPTION OF THE DRAWINGS

Embodiments of the invention will now be described, by way of example only, with reference to the accompanying schematic drawings, in which:
**Figure 1** is a schematic diagram of an exemplary assessment apparatus;
**Figure 2** schematically depicts a multi-beam charged particle-optical device, for example of the assessment apparatus of Figure 1;
**Figure 3** schematically depicts a multi-beam charged particle-optical device, for example of the assessment apparatus of Figure 1;
**Figure 4** schematically depicts an alternative multi-beam charged particle-optical device, for example of the assessment apparatus of Figure 1;
**Figure 5** schematically depicts an alternative multi-beam charged particle-optical device, for example of the assessment apparatus of Figure 1;
**Figure 6** is a schematic diagram of a discharge damage mitigation unit;
**Figure 7A-B** are schematic diagrams of a component and an extension element of a discharge damage mitigation unit, with the extension element in an extended position and in a retracted position;
**Figure 8** is a schematic diagram of a component and an extension element of a discharge damage mitigation unit, wherein the component is locally recessed in a region of the extension element;
**Figure 9** is a schematic diagram of an exemplary assessment apparatus comprising a discharge damage mitigation unit;
**Figure 10** is a schematic diagram of a plan view of a sample support having extension elements disposed thereon;
**Figure 11** is a schematic diagram of the distal end of an extension element;
**Figure 12A-C** are schematic diagrams of a discharge damage mitigation unit comprising an additional element - before discharge, during primary discharge and during secondary discharge.

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device.

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

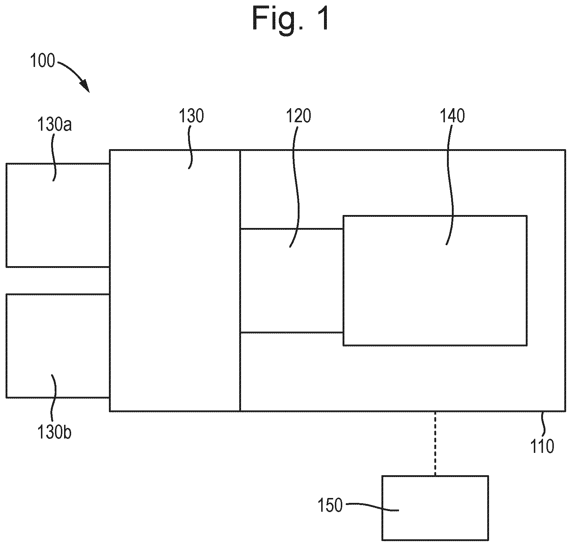

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

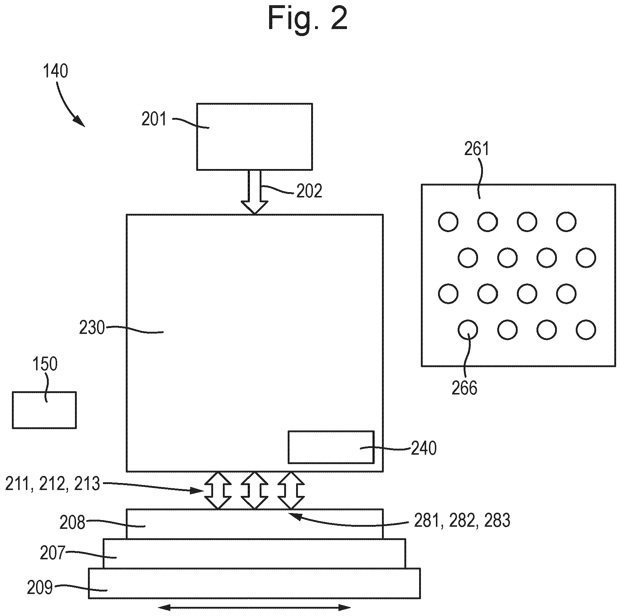

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208, which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

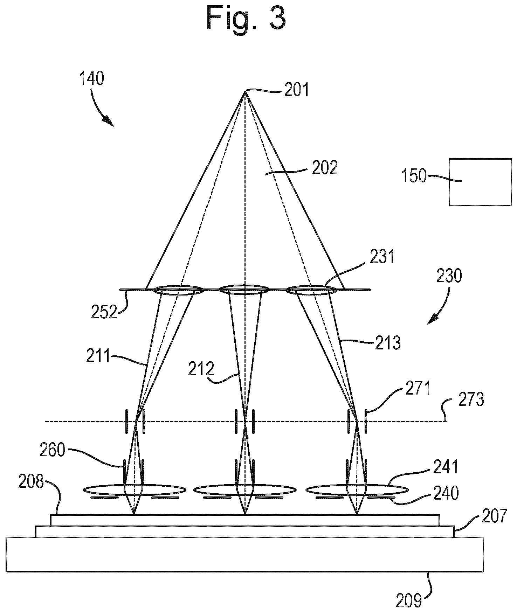

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 desirably at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens array that operates on the different beams to deflect the relative paths of the beams. The collimator array 271 may be electrostatic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

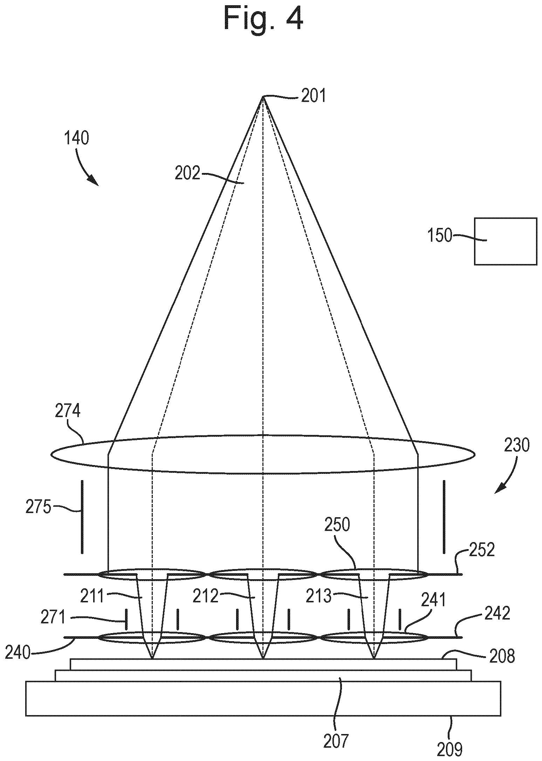

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

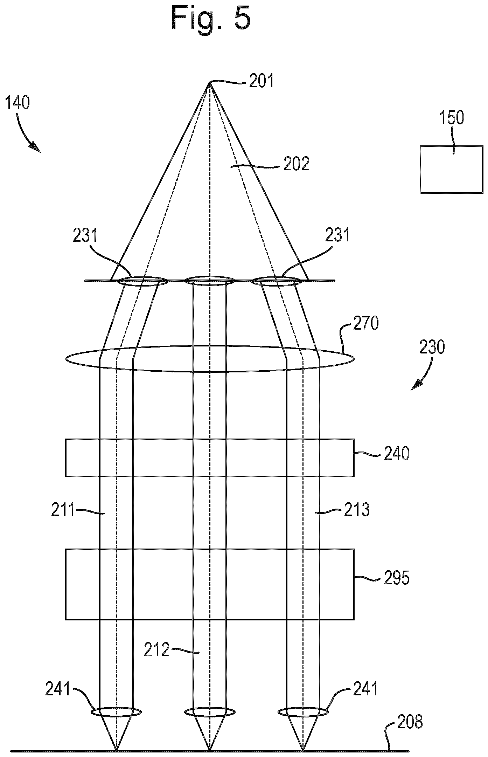

Figure 5 schematically depicts an electron-optical apparatus 140 of an assessment apparatus, e.g. the assessment apparatus 100 of Figure 1. The electron-optical apparatus 140 may be the electron-optical apparatus 140 of Figure 2 in which the electron-optical device 230 comprises a condenser lens array 231, a macro collimator 270, the detector array 240, a deflector array 295 and an objective lens array 241.

Features that are the same as those described above are given the same reference numerals. For conciseness, such features are not described in detail with reference to Figure 5. For example, the source 201, the condenser lens array 231, the objective lens array 241 and the sample 208 may be as described above.

The source is configured to generate a source beam 202. The condenser lens array 231 is configured to define a plurality of primary beams 211, 212, 213 from the source beam 202. The disclosure in EP1602121A1 of a lens array to split a beam into a plurality of beams, with the lens array providing a lens for each beam, is hereby incorporated by reference as a possible implementation of the condenser lens array 231.

In an embodiment the condenser lens array 231 comprises three plates 261 configured as an Einzel lens. An Einzel lens is configured to substantially ensure that the energy of an electron leaving the lens is the same as when the electron arrived at the lens. Such a lens maintains the energy of an electron between arriving and leaving the lens, for example the condenser lenses of the condenser lens array 231. Thus, dispersion only occurs within the condenser lens array 231 itself, thereby limiting chromatic aberrations. When a distance between the three plates of the Einzel lens is small, the chromatic aberrations caused by this condenser lens array 231 is limited, e.g. having a negligible effect.

In an embodiment the electron-optical device 230 comprises a collimator which may be macro collimator 270. The macro collimator 270 bends respective beams by an amount effective to ensure that a beam axis of each of the primary beams 211, 212, 213 derived from the primary 202 beam is incident on the sample 208 substantially normally (i.e. at substantially 90° to the nominal surface of the sample 208). In the current embodiment, the macro collimator 270 acts on all of the primary beams 211, 212, 213. The macro collimator 270 may comprise an electrostatic lens and/or a magnetic lens arrangement comprising a plurality of lens elements (e.g. a plurality of electrostatic and/or magnetic elements, e.g. forming a multipole).

In an embodiment the detector array 240 is configured to detect signal electrons by reference to the energy of the signal electron. For example, scintillators e.g. YAG do not directly detect electrons but generate light which is then detected. The signal electrons emitted from the sample 208 gain energy from the electromagnetic fields between the detector array 240 and the sample 208. In an embodiment, the objective lens array 241 is located between the detector array 240 and the sample 208.

The electron-optical device 230 may comprise a deflector array 295 located between the detector array 240 and the objective lens array 241. The deflector array 295 may be referred to as a beam separator. The deflector array 295 may deflect signal electrons resulting from individual primary beams 211, 212, 213 along a path towards detector elements of a detector array 240 that is away from the paths of the primary beams towards the sample 208. The deflector array 295 may comprise a magnetic deflector array that is configured to provide magnetic fields to disentangle the primary electrons projected toward the sample 208 from the signal (e.g. secondary) electrons emitted from the sample 208. The deflector array 295 may comprise a Wien filter array. The deflector array 295 may comprise an electrostatic deflector array that is arranged to cooperate with the magnetic deflector array to achieve the disentangling of the paths of the primary electrons and signal electrons.

The assessment apparatus 100 may comprise components configured to operate at a relatively high voltage, leading to potential differences between different components during use. The assessment apparatus 100 may be designed to account for the presence of a high electric field. Nonetheless, unintended electrical discharges still occur. A discharge can cause damage, particularly to the lower potential difference component. There is therefore a problem that components of the assessment apparatus, or even the sample 208 being assessed, may be damaged due to discharge. This damage may result in a loss of throughput of the assessment apparatus 100 due, for example, to downtime to perform repairs.

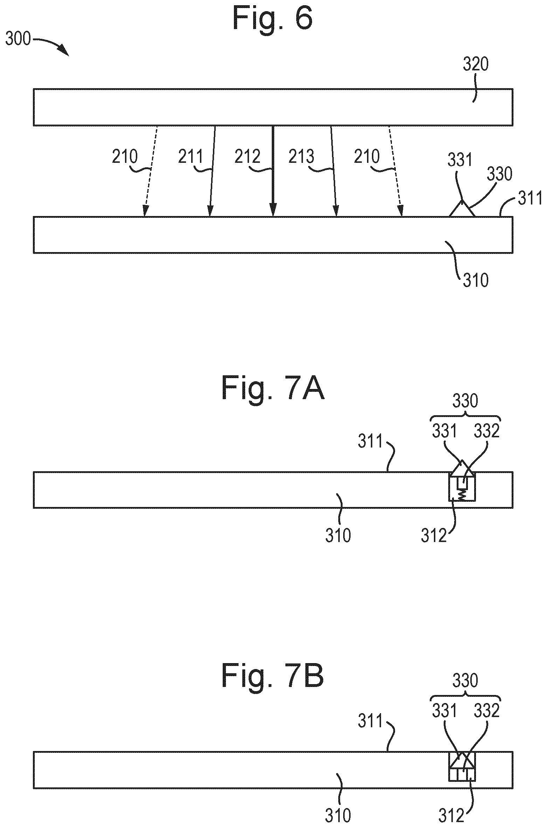

Figure 6 shows a discharge damage mitigation unit 300 for use in a charged particle beam assessment apparatus 100. The discharge damage mitigation unit 300 is configured for use in a high electric field environment. In particular, the discharge damage mitigation unit 300 is intended to reduce a likelihood and/or magnitude of damage to critical regions of the assessment apparatus 100 due to discharges between components having a potential difference therebetween. In this way, a throughput of the assessment apparatus 100 may be increased, as fewer samples 208 may be lost to damage and/or there may be less downtime to repair damaged components of the assessment apparatus 100.

The discharge damage mitigation unit 300 comprises one or more extension elements 330. Each extension element 330 is supported on a component 310 of the charged particle beam assessment apparatus 100. At least a distal region 331 of the extension element 330 is configured to protrude from a surface 311 of the component 310. The extension elements 330 are configured to receive a discharge from an element (referred to as a high electric field element 320) at a different electrical potential in the high electric field environment. Each extension element 330 is arranged outside of a beam path region 210 encompassing a beam path of the one or more beams 211, 212, 213 of charged particles. The discharge damage mitigation unit 300 optionally comprises the component 310 and/or the high electric field element 320. The surface 311 of the component 310 may face the high electric field element 320.

The extension element 330 may provide a, desirably relatively sharp, protrusion from the component 310 towards the high electric field element 320. In this way, the extension element 330 may to attract any discharge which emits from the high electric field element 320 towards the component 310. The extension element 330 provides a path for the discharge which is away from the more critical regions on and around the component 310, particularly the beam path. The extension element 330 is placed in a less critical region of the component 310 such that the discharge is attracted to the extension element 330 and is therefore unlikely to influence the more critical regions of the component 310. The chance of damage to critical regions on or around the component 310 is therefore mitigated by the extension elements 330. Furthermore, an intensity on the discharge may be reduced due to the presence of the one or more extension elements 330.

The discharge damage mitigation unit 300 of Figure 6 comprises one extension element 330. In other arrangements, the discharge damage mitigation unit 300 may comprise more than one extension element 330. For example, the discharge damage mitigation unit 300 may comprise a plurality of extension elements 330 arranged on the same component 310. In another arrangement, the discharge damage mitigation unit 300 may comprise a plurality of sets of one or more extension elements 320 wherein each set of one or more extension elements 330 may be disposed on a different, corresponding component.

The one or more extension elements 330 should preferably be placed far enough away from critical regions to reduce damage to the critical regions by discharges. However, the one or more extension elements 330 should preferably be placed close enough to the critical regions to attract discharges which would otherwise impact the critical regions. If the extension elements 330 are too far from the critical regions there is a danger that a discharge may find a path through the critical region rather than through the extension element 330. The exact placement of the extension elements 330 is therefore dependent on the application, and factors including the relative distance between the component 310 and the high electric field element 320.

A distance between the high electric field element 320 and the component 310 may, for example, be between 0.5 mm and 10 mm. A length of the extension element 330 may be between an order of around 10 microns to an order of around 1 mm. The length of the extension element 330 may be selected in proportion to the distance between the high electric field element 320 and the component 310. For example, the distance between the high electric field element 320 and the component 310 may be at the lower end of the range, around 0.5 mm to 1 mm and the extension element 330 may be in the order of approximately 10 microns long; whereas if the to distance between the high electric field element 320 and the component 310 were at the higher end of the range, around 8 mm to 10 mm, the extension element 330 may be in the order of approximately 1 mm long.

Figure 7A shows a cross-sectional view through a component 310 of a discharge damage mitigation unit 300 having the features described above in reference to Figure 6. In some arrangements, for example as shown in Figure 7A, the component 310 may define a pocket 312 configure to receive at least part of the extension element 330. At least a proximal region 332 of the extension element 330 is configured to be received within the pocket 312 defined in the component 310. In this way, the proximal region 332 of the extension element 330 may be securely held in the component 310 and may provide a path through the component 330 away from the surface 311 of the component 310.

The discharge damage mitigation unit 300 may be configured such that the extension element 330 is in a fixed position (i.e., fixed in an extended position). Alternatively, the discharge damage mitigation unit 300 may be configured to move the extension element 330 between an extended position and a retracted position. Figure 7A shows a cross-sectional view through a component 310 of a discharge damage mitigation unit 300 in the extended position. Figure 7B shows the discharge damage mitigation unit 300 of Figure 7A in the retracted position. In the extended position, the distal region 331 of the extension element 330 protrudes a greater distance from the surface 311 of the component 330 than in the retracted position. In other words, in the extended position, less of the extension element 330 is housed within the pocket 312 than in the retracted position. In some arrangements, in the retracted position the distal end 331 of the extension element 330 may be received, and optionally entirely housed, within the pocket 312 defined in the component 310.

The one or more extension elements 330 are optionally configured to be removable. In this way, the extension elements 330 may be readily replaced if damaged by discharges.

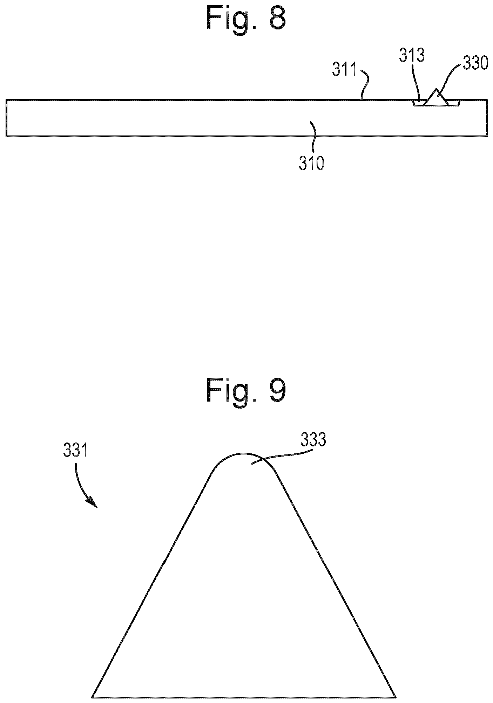

Figure 8 shows a cross-sectional view through a component 310 of a discharge damage mitigation unit 300, such as that of Figure 6. The component 310 is recessed 313 in a region surrounding the extension element 330. In this way, the extension element 330 protrudes farther from the recess 313 in a region locally around that extension element 330 than the extension element 330 protrudes from the surface 311 of the component 310 globally, in regions more remote from the extension element 310. In this way, the local relative height of the extension element 300 is greater. This may increase a likelihood of the discharge being attracted to the extension element 330, without increasing an actual height of the extension element 330 over the surface 311 of the component 330. The extension element 330 and recess 313 may therefore act together to provide a more compact, reliable and effective mitigation against damage due to discharge. A similar recess 313 is optionally present in the component 310 of the arrangements described above in reference to Figures 7A and 7B.

The shape of the extension element 330 is not particularly limited, and may be selected based on the application and dimensions/arrangement of surrounding components and elements. For example, the extension element 330 may be a pin, having a substantially cylindrical or cuboid shape.

Figure 9 shows the distal region 331 of an extension element 330 having a preferred shape. At least a distal region 331 of the extension element 330 preferably has a substantially conical shape. The distal region 331 of the extension element 330 may be connected to a proximal region 332 of the extension element 330. The proximal region 332 may have a different shape than the distal region 331. For example, the proximal region 332 may have a substantially cylindrical or cuboid shape. In another arrangement, the entire extension element 330 may have the substantially conical shape, and optionally is provided directly on the surface 311 of the component 310.

The extension element 330 comprises a tip 333 at a most distal end of the distal region 331. As is shown, for example, in Figure 9, the tip 333 preferably has a dome shape. In other words, the tip 333 may from a semi-spherical shape. The dome may have a radius between 1 microns and 30 microns. A size of the tip 333, e.g., the diameter of the dome, may be selected in proportion to the distance between the high electric field element 320 and the component 310. For example, the distance between the high electric field element 320 and the component 310 may be at the lower end, of around 0.5 mm to 1 mm and the tip 333 of the extension element 330 may be approximately 2 to 4 microns diameter; whereas if the distance between the high electric field element 320 and the component 310 were at the higher end, around 8 mm to 10 mm, the tip 333 of the extension element 330 may be approximately 40 to 60 microns diameter.

The extension element 330 may be formed of any material suitable for attracting a discharge from the high electric field component 320. The extension element 330 is desirably formed of, or coated with, a material which is unlikely to contaminate the assessment apparatus 100, even when the extension element 330 is subjected to discharges. The extension element 330 may comprise or consist of the same material used to form surrounding components, for example the component 310. It may be further desirable for the extension element 330 to be formed of a material which is easily made into the desired shape of the extension element 300, for example having a relatively sharp tip.

The extension element 330 may, for example, comprise or consist of any material with a crystalline atomic-structure. The extension element preferably comprises or consists of a non-copper metal or silicon. These materials have a low likelihood of resulting in contamination. The non-copper metal is preferably a non-magnetic metal. The extension element may, for example, comprises or consist of molybdenum or titanium.

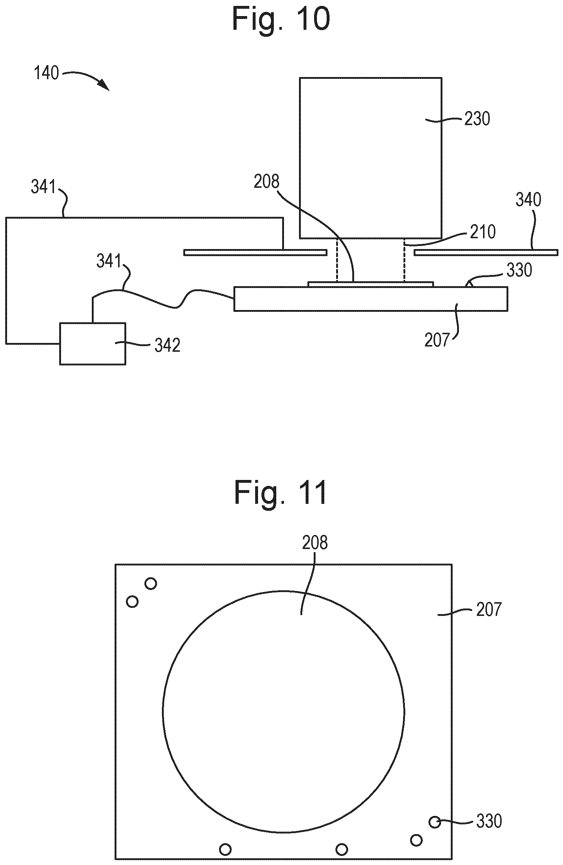

Figure 10 shows an electron-optical apparatus 140 having a discharge damage mitigation unit. In the arrangement of Figure 10, the component on which the one or more extension elements 330 are provided is a sample support 207 configured to support the sample 208 at a sample support area of the sample support. The one or more extension elements 330 are arranged outside of the sample support area. In this way, even if/when the sample support 207 moves on an actuated stage 209, the one or more extension elements 330 will remain outside of the beam path region 210. This is because the beam path will intersect the sample 208.

The electron-optical apparatus 140 of Figure 10 further further comprises a shielding plate 340 disposed upbeam of the sample support 207. In other words, the charged particles will pass through an aperture of the shielding plate 340 on the beam path towards the sample support area. The shielding plate 340 acts as the high electric field element of the discharge damage mitigation unit. In other words, the one or more extension elements are configured to receive a discharge from the shielding plate 340. In the arrangement of Figure 10, the one or more extension elements 330 are arranged to protrude from the sample support 207 towards the shielding plate 340.

The shielding plate 340 and the sample support 207 may be configured to be at the same electrical potential during use. For example, the shielding plate 340 and the sample support 207 may be connected by wires 341, and optionally also via one or more units 342. However, the wires 341 may provide a path between the shielding plate 340 and the sample support 207 significantly longer than a minimum distance between the shielding plate 340 and the sample support 207. In particular, in order to allow the sample support 207 to move (together with an actuated stage 209 on which the sample support 207 is mounted), there may be slack in the wires 341. Therefore, in the case of a discharge, the current may take a shortest path between the shielding plate 340 and the sample support 207, rather than flowing through the wires 341. The discharge may be attracted to the one or more extension elements 330. The extension elements 330 on the sample support 207 may therefore reduce a likelihood of damage to the sample support 207 or to a sample 208 on the sample support 207. In particular, it is likely that, in the absence of the extension elements 330, the discharge may take a shortest path through one or more features of the sample 208. This could potentially cause damage to the sample 208 making it partially or fully un-usable or unsuitable for further processing. Furthermore, a discharge through the sample 208 may result in a release of contaminants into the apparatus; whereas the extension elements 330 may be formed of a material selected to have low likelihood of releasing contaminant particles.

The one or more extension elements 330 are configured to protrude from the sample support 207 by a predetermined distance. For example, as described above in relation to Figures 7A and 7B, the extension elements 330 may be fixed in place and have a set predetermined distance. Alternatively, the discharge damage mitigation unit may be configured to move between an extended position and a retracted portion. In the extended position the extension elements 330 protrude from the sample support 207 (or, if present, a recess in the sample support 207 locally in a region around the extension element 330) by the predetermined distance. The predetermined distance is optionally at least 70% of the thickness of the sample 208. In a preferred arrangement, the predetermined distance is equal to or greater than a thickness of the sample 208. For example, the predetermined distance may be greater than a distance between the sample support 207 and an upbeam side of the sample 208. In other words, the extension element 330 may optionally be configured to protrude above a height of the surface of the sample 208 facing the electron-optical device 230. In this way, a likelihood of discharge impacting the sample 208 may be reduced.

In the arrangement of Figures 10 and 11, a distance between the high electric field element 320 and the component 310 may, for example, be between 5 mm and 10 mm, preferably between 6 mm and 9 mm, more preferably between 7 mm and 8 mm. A length of the extension element 330 may be between 500 microns and 1 mm, preferably between 600 microns and 900 microns, more preferably between 700 microns and 800 microns. The tip 333 may have a width, or diameter, between 20 microns and 60 microns, preferably between 30 microns and 50 microns, more preferably 40 microns. The length of the extension element 330 and the width, or diameter, of the tip 333 may be selected in proportion to the distance between the high electric field element 320 and the component 310.

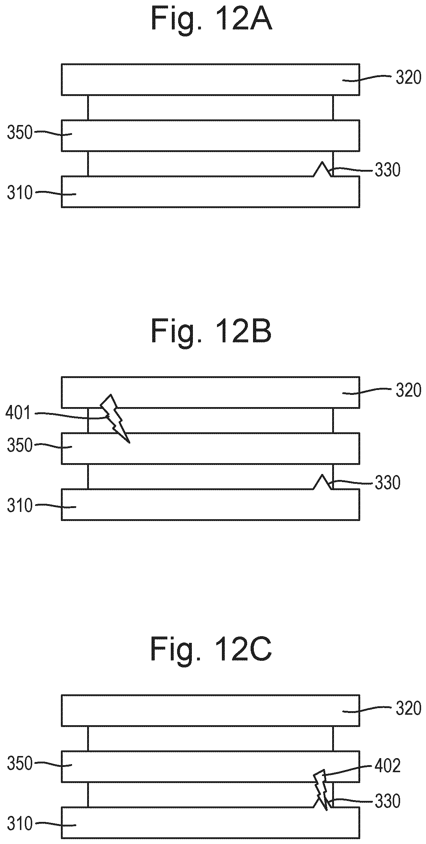

Figures 12A-C depicts a discharge damage mitigation unit 300 comprising a high electric field element 320 and a component 310, wherein one or more extension elements 330 protrude towards the high electric field element 320, similarly to the arrangement of Figure 6. The discharge damage mitigation unit 300 further comprises an additional element 350. In the arrangement of Figures 12A-C, the additional element 350 is disposed between the high electric field element 320 and the component 310. Figures 12A-C each depict this discharge damage mitigation unit 300 in a different situation.

In Figure 12A, the discharge damage mitigation unit 300 is in a normal situation. In other words, Figure 12A depicts the discharge damage mitigation unit 300 during regular operation of the assessment apparatus 100, when no discharge is occurring between the high electric field element 320, the additional element 350. The discharge damage mitigation unit 300 may be configured such that, in this normal situation, the high electric field element 320 is at a higher electric potential than the additional element 350. For example, the additional element 350 may be at ground potential. In this way, there may be a potential difference between the additional element 350 and the high electric field element 320. There may therefore be a high electric field between the additional element 350 and the high electric field element 320. In contrast, there may be no potential difference between the additional element 350 and the component 310. There may therefore be no electric field between the additional element 350 and the component 310.

In Figure 12B, the discharge damage mitigation unit 300 is in a primary discharge situation. In this situation, a primary discharge 401 occurs between the high electric field element 320 and the additional element 350. This primary discharge 401 may increase an electric potential of the additional element 350. A potential difference may exist between the additional element 350 and the component 310 due to the primary discharge 401. In other words, the primary discharge 401 may result in a high electric field between the additional element 350 and the component 310.

In Figure 12C, the discharge damage mitigation unit 300 is in a secondary discharge situation. In this situation, a secondary discharge 402 occurs between the additional element 350 and the component 310, as a result of the potential difference between the additional element 350 and the component 310 caused by the primary discharge 402. The one or more extension elements 330 are configured to receive the secondary discharge 402.

The one or more extension elements 330 can be placed at non-critical regions of the component 310. In particular, the one or more extension elements 330 are arranged outside of a beam path region 210 encompassing a beam path of the one or more beams 211, 212, 213 of charged particles. Furthermore, the one or more extension elements 330 are preferably relatively sharp compared to other features of the component 310. The sharp, protruding nature of the one or more extension elements 330 may reduce a potential difference between the additional elements 250 and the component 310, compared to an arrangement not having the one or more extension elements 330.

The one or more extension elements 330 may beneficially reduce a likelihood and/or intensity of damage resulting from the secondary discharge 402. In the absence of the one or more extension elements 330, the secondary discharge 402 may be more intense and/or may de received in a critical region of the component 310, and thus would be more likely to result in damage to the component 310. Furthermore, in the absence of the one or more extension elements 330, the secondary discharge 402 to the component 310 may result in a release of contaminants. Whereas, the one or more extension elements 330 may be made, for example through selection of appropriate materials, such that contamination is less likely. Contamination and/or damage to the component 310 is undesirable because the damage may negatively impact the performance of the assessment apparatus 100 and/or may result in more downtime to perform maintenance and repairs.

The component 310, the high electric field element 320, and optionally the additional element 350, may be comprised of parts of an objective lens and detector stack of the charged particle beam assessment apparatus 100. For example, one ore more of the component 310, the high electric field element 320, and the additional element 350 may be comprised within or between the detector array 240 and the objective lens array 241 of the electron-optical apparatus 140 of Figure 3, or the detector array 240 and the beam limiting aperture array 252 of the electron-optical apparatus 140 of Figure 4, as described above. Similarly, the component 310, the high electric field element 320, and the additional element 350 may be comprised within the objective lens array 241 of the electron-optical apparatus 140 of Figure 5, as described above.

In the arrangement of Figures 12A-C, a distance between the high electric field element 320 and the component 310 may, for example, be between 0.5 mm and 5 mm, preferably between 1 mm and 4 mm, more preferably between 2 mm and 3 mm. A length of the extension element 330 may be between 10 microns and 400 microns, preferably between 20 microns and 100 microns, more preferably between 30 microns and 50 microns. The tip 333 may have a width, or diameter, between 1 microns and 20 microns, preferably between 3 microns and 10 microns, more preferably between 5 and 8 microns. The length of the extension element 330 and the width, or diameter, of the tip 333 may be selected in proportion to the distance between the high electric field element 320 and the component 310.

Further embodiments include the following numbered clauses:
1. A discharge damage mitigation unit for use in a charged particle beam assessment apparatus for projecting a beam of charged particles towards a sample, wherein
   the discharge damage mitigation unit is configured for use in a high electric field environment;
   the discharge damage mitigation unit comprises one or more extension elements configured to receive a discharge from a high electric field element at a different electrical potential in the high electric field environment;
   each extension element
   is arranged outside of a beam path region encompassing a beam path of the beam of charged particles, and
   is supported on a component of the charged particle beam assessment apparatus, wherein a distal region of the extension element is configured to protrude from a surface of the component.
2. The discharge damage mitigation unit of clause 1, wherein a proximal region of the extension element is configured to be received within a pocket defined in the component.
3. The discharge damage mitigation unit of clause 2, wherein the discharge damage mitigation unit is configured to move the extension element between an extended position and a retracted position, wherein in the extended position the distal region of the extension element protrudes a greater distance from the surface of the component than in the retracted position.
4. The discharge damage mitigation unit of clause 3, wherein in the retracted position the distal end of the extension element is received within the pocket defined in the component.
5. The discharge damage mitigation unit of any preceding clause, wherein the extension element comprises a tip at a most distal end of the distal region, wherein the tip has a dome shape.
6. The discharge damage mitigation unit of clause 5, wherein the dome has a radius between 1 microns and 30 microns.
7. The discharge damage mitigation unit of any preceding clause, wherein the distal region has a substantially conical shape.
8. The discharge damage mitigation unit of any preceding clause, further comprising the component, wherein the component is recessed in a region surrounding the extension element.
9. The discharge damage mitigation unit of any preceding clause, wherein the extension element comprises or consists of any material with a crystalline atomic-structure.
10. The discharge damage mitigation unit of any preceding clause, wherein the extension element comprises or consists of a non-copper metal or silicon.
11. The discharge damage mitigation unit of clause 10, wherein the extension element comprises or consists of molybdenum or titanium.
12. The discharge damage mitigation unit of any preceding clause, wherein a distance between the high electric field element and the component is between 0.5mm and 10mm.
13. The discharge damage mitigation unit of any preceding clause, wherein the component is a sample support configured to support the sample at a sample support area of the sample support, and wherein the one or more extension elements are arranged outside of the sample support area.
14. The discharge damage mitigation unit of clause 13, further comprising a shielding plate disposed upbeam of the sample support, wherein the shielding plate is the high electric field element and wherein the one or more extension elements are configured to receive a discharge from the shielding plate.
15. The discharge damage mitigation unit of clause 14, wherein the shielding plate and the sample support are configured to be at the same electrical potential during use.
16. The discharge damage mitigation unit of either of any of clauses 13 to 15, wherein the one or more extension elements are configured to protrude from the sample support by a predetermined distance, wherein the predetermined distance is greater than a thickness of the sample.
17. The discharge damage mitigation unit of clause 16, wherein the predetermined distance is greater than a distance between the sample support and an upbeam side of the sample.
18. The discharge damage mitigation unit of any of clauses 1 to 12, further comprising an additional element,
   wherein the discharge comprises
   a primary discharge from the high electric field element, wherein the additional element is configured to receive the primary discharge, and
   a secondary discharge from the additional element, wherein the one or more extension elements are configured to receive the secondary discharge.
19. The discharge damage mitigation unit of clause 18, wherein the additional element is disposed between the high electric field element and the component.
20. The discharge damage mitigation unit of either of clauses 18 and 19, wherein the component and the high electric field element are comprised of parts of an objective lens and detector stack of the charged particle beam assessment apparatus.
21. A charged particle beam assessment apparatus for projecting a beam of charged particles towards a sample, comprising the discharge damage mitigation unit of any of the preceding clauses.

Although specific reference may be made in this text to embodiments of the invention in the context of an electron microscope, embodiments of the invention may be used in other types of apparatus. Embodiments of the invention may form part of a mask inspection apparatus, a metrology apparatus, or any apparatus that measures or processes an object such as a wafer (or other substrate) or mask (or other patterning device).

Although specific reference may have been made above to the use of embodiments of the invention in the context of sample assessment, it will be appreciated that the invention, where the context allows, is not limited to sample assessment and may be used in other applications, for example electron beam lithography.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A discharge damage mitigation unit for use in a charged particle beam assessment apparatus for projecting a beam of charged particles towards a sample, wherein
the discharge damage mitigation unit is configured for use in a high electric field environment;
the discharge damage mitigation unit comprises one or more extension elements configured to receive a discharge from a high electric field element at a different electrical potential in the high electric field environment;
each extension element
is arranged outside of a beam path region encompassing a beam path of the beam of charged particles, and
is supported on a component of the charged particle beam assessment apparatus,
wherein a distal region of the extension element is configured to protrude from a surface of the component.

2. The discharge damage mitigation unit of claim 1, wherein a proximal region of the extension element is configured to be received within a pocket defined in the component.

3. The discharge damage mitigation unit of claim 2, wherein the discharge damage mitigation unit is configured to move the extension element between an extended position and a retracted position, wherein in the extended position the distal region of the extension element protrudes a greater distance from the surface of the component than in the retracted position.

4. The discharge damage mitigation unit of any preceding claim, wherein the extension element comprises a tip at a most distal end of the distal region, wherein the tip has a dome shape.

5. The discharge damage mitigation unit of any preceding claim, wherein the distal region has a substantially conical shape.

6. The discharge damage mitigation unit of any preceding claim, further comprising the component, wherein the component is recessed in a region surrounding the extension element.

7. The discharge damage mitigation unit of any preceding claim, wherein the extension element comprises or consists of any material with a crystalline atomic-structure.

8. The discharge damage mitigation unit of any preceding claim, wherein the extension element comprises or consists of a non-copper metal or silicon.

9. The discharge damage mitigation unit of any preceding claim, wherein the component is a sample support configured to support the sample at a sample support area of the sample support, and wherein the one or more extension elements are arranged outside of the sample support area.

10. The discharge damage mitigation unit of claim 9, further comprising a shielding plate disposed upbeam of the sample support, wherein the shielding plate is the high electric field element and wherein the one or more extension elements are configured to receive a discharge from the shielding plate.

11. The discharge damage mitigation unit of claim 10, wherein the shielding plate and the sample support are configured to be at the same electrical potential during use.

12. The discharge damage mitigation unit of either of any of claims 9 to 11, wherein the one or more extension elements are configured to protrude from the sample support by a predetermined distance, wherein the predetermined distance is greater than a thickness of the sample.

13. The discharge damage mitigation unit of any of claims 1 to 8, further comprising an additional element,
wherein the discharge comprises
a primary discharge from the high electric field element, wherein the additional element is configured to receive the primary discharge, and
a secondary discharge from the additional element, wherein the one or more extension elements are configured to receive the secondary discharge.

14. The discharge damage mitigation unit of claim 13, wherein the additional element is disposed between the high electric field element and the component.

15. A charged particle beam assessment apparatus for projecting a beam of charged particles towards a sample, comprising the discharge damage mitigation unit of any of the preceding claims.
